# EUROPEAN PATENT APPLICATION

(11) **EP 2 071 620 A1**
(43) Date of publication of application: **17.06.2009**
(21) Application number: 07024082.5
(22) Date of filing: 12.12.2007
(51) Int. Cl.: H01L 23/367, H01L 23/373, H01L 33/00

(54) **Heat sink having enhanced heat dissipation capacity**

(71) Applicant: Chyn, Wen-Long, Yingko Chen Taipei Hsien (TW); Hsu, Te-Ching, Qianzhen District Kaohsiung City (TW)
(72) Inventor: Chyn, Wen-Long, Yingko Chen Taipei Hsien (TW); Hsu, Te-Ching, Qianzhen District Kaohsiung City (TW)
(74) Representative: Reichel, Wolfgang

(57) **Abstract**

A heat sink includes a metallic heat conducting layer (1), a non-metallic heatsink layer (2) combined with the metallic heat conducting layer and having a porous structure, and a hollow receiving space (4) defined between the metallic heat conducting layer (1) and the non-metallic heatsink layer (2). Thus, the heat produced by a heat source (A) is conducted quickly and distributed evenly on the metallic heat conducting layer to create an evenly heat conducting effect, while the hollow receiving space (4) has a heat convection effect to quickly transfer the heat from the metallic heat conducting layer (1) to the non-metallic heatsink layer (2) which produces a heatsink effect to dissipate the heat so that the heat is dissipated quickly by provision of the metallic heat conducting layer (1), the hollow receiving space (4) and the non-metallic heatsink layer (2).

## Description

The present invention relates to a heat sink and, more particularly, to a heat sink for an electronic device, such as a CPU (central processing unit), LED (light emitting diode), IC (integrated circuit), rectifier, resistor, capacitor, inductor, and the like.

An electronic device or element, such as the CPU (central processing unit), LED (light emitting diode), IC (integrated circuit), rectifier, resistor, capacitor, inductor, and the like, is a heat source and easily produces heat having a high temperature during operation, so that it is necessary to provide a heat sink to carry away the heat produced by the electronic device or element so as to achieve a heat dissipation effect. A conventional heat sink generally comprises a heatsink element, such as a metallic heatsink fin, a heat conductive tube, a chill enabling chip, a heat dissipation board, a cooling fan and the like, so as to achieve a heat dissipation effect. However, the conventional heat sink cannot dissipate the heat from the heat source exactly and quickly, thereby greatly decreasing the heat dissipation efficiency. In addition, the conventional heat sink has a very complicated construction, thereby increasing the costs of fabrication.

The primary objective of the present invention is to provide a heat sink having an enhanced heat dissipation capacity to dissipate heat from a heat source quickly.

In accordance with the present invention, there is provided a heat sink, comprising a metallic heat conducting layer, a non-metallic heatsink layer combined with the metallic heat conducting layer and having a porous structure, and a hollow receiving space defined between the metallic heat conducting layer and the non-metallic heatsink layer.

Thus, there is provided a heat sink, wherein the heat produced by the heat source is conducted quickly and distributed evenly on a metallic heat conducting layer to create an evenly heat conducting effect, while a hollow receiving space has a heat convection effect to quickly transfer the heat from the metallic heat conducting layer to a non-metallic heatsink layer which produces a heatsink effect to dissipate the heat so that the heat produced by the heat source is dissipated quickly by provision of the metallic heat conducting layer, the hollow receiving space and the non-metallic heatsink layer.

Further benefits and advantages of the present invention will become apparent after a careful reading of the detailed description with appropriate reference to the accompanying drawings.

In the drawings:
Fig. 1 is a front cross-sectional assembly view of a heat sink in accordance with a preferred embodiment of the present invention.
Fig. 2 is a front cross-sectional assembly view of a heat sink in accordance with another preferred embodiment of the present invention.
Fig. 3 is a front cross-sectional assembly view of a heat sink in accordance with another preferred embodiment of the present invention.
Fig. 4 is a front cross-sectional assembly view of a heat sink in accordance with another preferred embodiment of the present invention.
Fig. 5 is a front cross-sectional assembly view of a heat sink in accordance with another preferred embodiment of the present invention.
Fig. 6 is a front cross-sectional assembly view of a heat sink in accordance with another preferred embodiment of the present invention.
Fig. 7 is a front cross-sectional assembly view of a heat sink in accordance with another preferred embodiment of the present invention.
Fig. 8 is a front cross-sectional assembly view of a heat sink in accordance with another preferred embodiment of the present invention.
Fig. 9 is a front cross-sectional assembly view of a heat sink in accordance with another preferred embodiment of the present invention.
Fig. 10 is a front cross-sectional assembly view of a heat sink in accordance with another preferred embodiment of the present invention.
Fig. 11 is a locally enlarged view of the heat sink as shown in Fig. 10. Fig. 12 is a front cross-sectional assembly view of a heat sink in accordance with another preferred embodiment of the present invention.
Fig. 13 is a front cross-sectional assembly view of a heat sink in accordance with another preferred embodiment of the present invention.
Fig. 14 is a front cross-sectional assembly view of a heat sink in accordance with another preferred embodiment of the present invention.
Fig. 15 is a front cross-sectional assembly view of a heat sink in accordance with another preferred embodiment of the present invention.
Fig. 16 is a front cross-sectional assembly view of a heat sink in accordance with another preferred embodiment of the present invention.

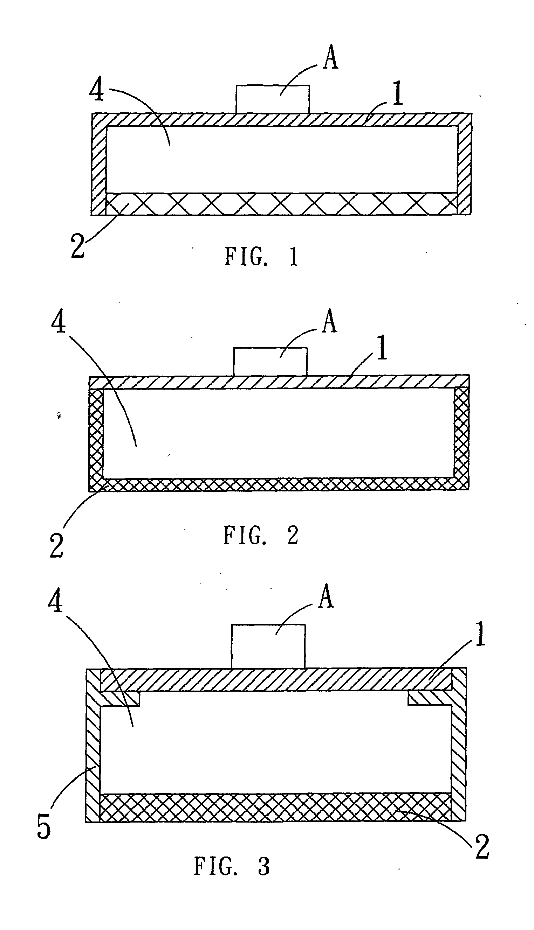

Referring to the drawings and initially to Fig. 1, a heat sink in accordance with the preferred embodiment of the present invention comprises a metallic heat conducting layer 1, a non-metallic heatsink layer 2 combined with the metallic heat conducting layer 1, and a hollow receiving space 4 defined between the metallic heat conducting layer 1 and the non-metallic heatsink layer 2.

The metallic heat conducting layer 1 is made of a metal having great heat conductivity, such as gold, silver, copper, iron, aluminum, cobalt, nickel, zinc, titanium, manganese and the like. The non-metallic heatsink layer 2 is made of non-metallic powder having good heat conductivity, such as Al₂O₃, Zr₂O, AlN, SiN, BN, WC, SiC, C, ReSiC and the like. The non-metallic heatsink layer 2 has a porous structure so that the air contained in the hollow receiving space 4 can pass through the non-metallic heatsink layer 2 to produce a heat convection effect.

As shown in Fig. 1, the hollow receiving space 4 is formed by the metallic heat conducting layer 1. The metallic heat conducting layer 1 has a hollow inside to define the hollow receiving space 4 and has an open end for mounting the non-metallic heatsink layer 2. Thus, the hollow receiving space 4 has an open end sealed by the non-metallic heatsink layer 2.

When in use, a heat source (A) is mounted on the metallic heat conducting layer 1. Thus, the heat produced by the heat source (A) is conducted quickly and distributed evenly on the metallic heat conducting layer 1 to create an evenly heat conducting effect. At the same time, the hollow receiving space 4 has a heat convection effect to quickly transfer the heat from the metallic heat conducting layer 1 to the non-metallic heatsink layer 2 which produces a heatsink effect to dissipate the heat so that the heat produced by the heat source (A) is dissipated quickly by provision of the metallic heat conducting layer 1, the hollow receiving space 4 and the non-metallic heatsink layer 2.

As shown in Fig. 2, the hollow receiving space 4 is formed by the non-metallic heatsink layer 2. The non-metallic heatsink layer 2 has a hollow inside to define the hollow receiving space 4 and has an open end for mounting the metallic heat conducting layer 1. Thus, the hollow receiving space 4 has an open end sealed by the metallic heat conducting layer 1.

Referring to Fig. 3, the heat sink further comprises a packing layer 5 mounted between the metallic heat conducting layer 1 and the non-metallic heatsink layer 2, wherein the hollow receiving space 4 is formed by the packing layer 5. The packing layer 5 has a hollow inside to define the hollow receiving space 4 and has an open first end for mounting the metallic heat conducting layer 1 and an open second end for mounting the non-metallic heatsink layer 2. Thus, the hollow receiving space 4 has two open ends sealed by the metallic heat conducting layer 1 and the non-metallic heatsink layer 2 respectively.

In fabrication, the non-metallic heatsink layer 2 is made by the steps of preparing material, rolling press kneading, extruding, elongating and drying. In the step of preparing material, non-metallic powders (such as Al₂O₃, Zr₂O, AlN, SiN, BN, WC, SiC, C, ReSiC and the like) having good heat conductivity are prepared. The non-metallic powders have particles of different diameters ranged between 20µm and 200µm. A binder (such as silicon colloid, aluminum colloid, zirconium colloid, and the like) having a determined proportion, and a plasticizer (such as starch, lignin, sodium lignosulfonate lignin, calcium lignosulfonate lignin, methyl cellulose and the like) having a determined proportion are added into the non-metallic powders. In addition, metallic powders (such as gold, silver, copper, iron, aluminum, cobalt, nickel, zinc, titanium, manganese and the like) having great heat conductivity can be added into the non-metallic powders according to the requirement. Thus, the metallic powders and the non-metallic powders are mixed to form composite powders having particles of different diameters ranged between 50µm and 500µm to enhance the heat dissipation capacity. In the step of rolling press kneading, the non-metallic powders (or the composite powders of the non-metallic powders and the metallic powders) having good heat conductivity, the binder and the plasticizer are treated by a rolling press kneading process so that the surface of each of the powders has a layer of evenly distributed binder and plasticizer. In the step of extruding, the powders are treated by a vacuum extruding process so that the powders are extruded to form a blank having a sheet shape. In the step of elongating, the blank is treated by an elongating process so that the blank has a uniform density. In the step of drying, the blank is dried to form the non-metallic heatsink layer 2. Thus, the non-metallic heatsink layer 2 has a highly porous structure and contains non-metallic powders having good heat conductivity, wherein the non-metallic heatsink layer 2 has a porosity ranged between 20% and 80%, and the non-metallic powders have particles of different diameters ranged between 20µm and 200µm.

Alternatively, the step of extruding and the step of elongating are replaced by a step of die press molding (such as stamping molding, uniform pressure molding, vibration press molding and the like). In the step of die press molding, the powders are pressed to form a blank having a predetermined shape, such as a sheet shape or a matrix shape, and the blank is directly formed with the hollow receiving space 4. Then, the blank is dried to form the non-metallic heatsink layer 2 having a porous structure.

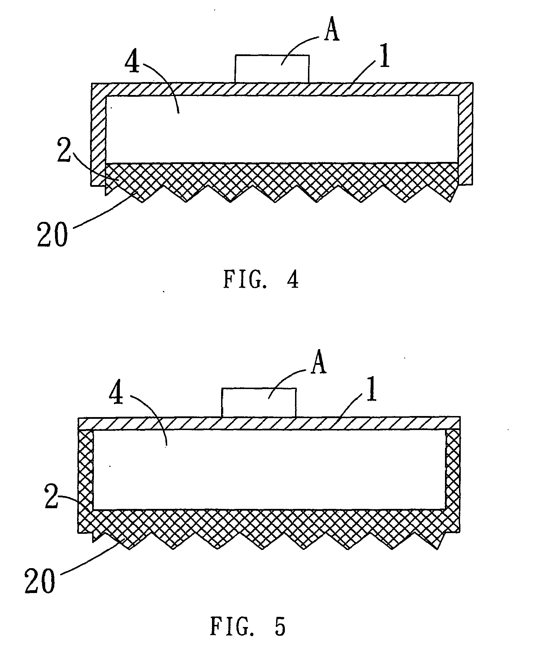

As shown in Figs. 4 and 5, the non-metallic heatsink layer 2 has a three-dimensional heat dissipation face 20 which has a predetermined shape and has a matrix arrangement. Thus, the non-metallic heatsink layer 2 has a larger surface area by provision of the three-dimensional heat dissipation face 20 to enhance the heat dissipation effect.

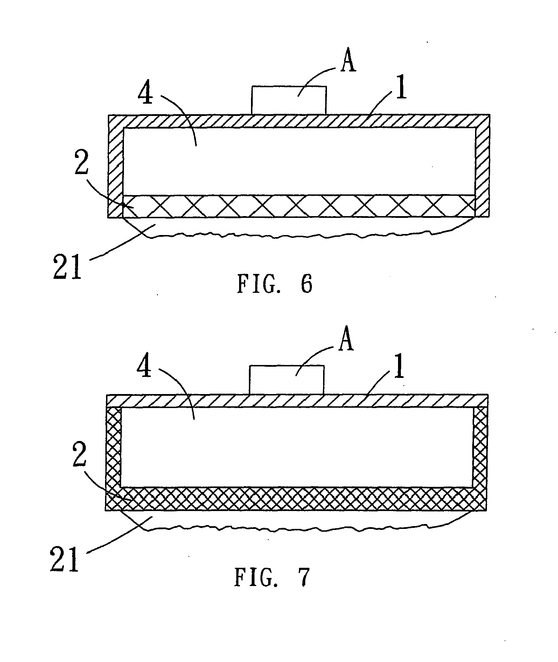

Referring to Figs. 6 and 7, the heat sink further comprises a three-dimensional dot-matrix heatsink layer 21 mounted on a surface of the non-metallic heatsink layer 2 and arranged in an irregular manner. Thus, the non-metallic heatsink layer 2 has a larger surface area by provision of the three-dimensional dot-matrix heatsink layer 21 to enhance the heat dissipation effect.

In fabrication, the non-metallic heatsink layer 2 is further made by the steps of: preparing slurry, heating, spraying and sintering. The step of preparing slurry includes preparing materials the same as that of the non-metallic heatsink layer 2 and mixing and stirring the materials to form a slurry. In the step of heating, the non-metallic heatsink layer 2 (which has been sintered) is pre-heated. In the step of spraying, the slurry is sprayed evenly onto the surface of the non-metallic heatsink layer 2. In the step of sintering, the non-metallic heatsink layer 2 and the slurry are sintered, so that the non-metallic heatsink layer 2 and the slurry are combined together. Thus, the particles contained in the slurry are attached to the non-metallic heatsink layer 2 so that the surface of the non-metallic heatsink layer 2 is provided with the three-dimensional dot-matrix heatsink layer 21 which has a particle shape. In such a manner, the particles of the three-dimensional dot-matrix heatsink layer 21 have different sizes and are arranged in an irregular manner.

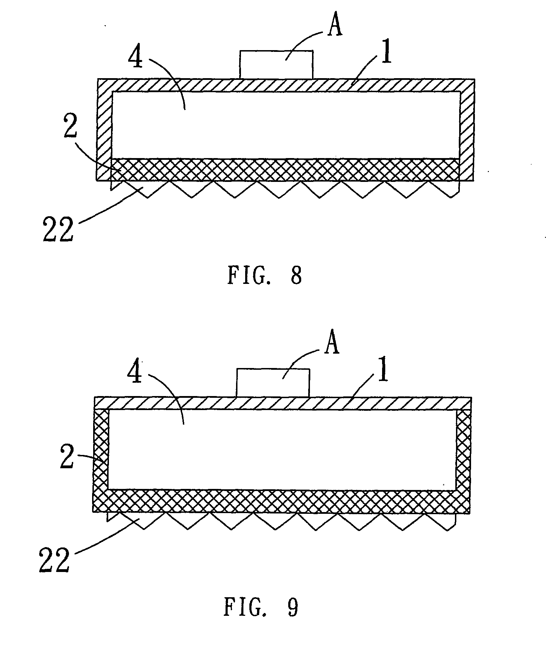

Referring to Figs. 8 and 9, the heat sink further comprises a three-dimensional dot-matrix heatsink layer 22 mounted on a surface of the non-metallic heatsink layer 2 and arranged in a regular manner. Thus, the non-metallic heatsink layer 2 has a larger surface area by provision of the three-dimensional dot-matrix heatsink layer 22 to enhance the heat dissipation effect.

In fabrication, the step of spraying is replaced by a step of printing or stamping. Then, in the step of sintering, the non-metallic heatsink layer 2 and the slurry are sintered, so that the non-metallic heatsink layer 2 and the slurry are combined together. Thus, the particles contained in the slurry is attached to the non-metallic heatsink layer 2 so that the surface of the non-metallic heatsink layer 2 is provided with the three-dimensional dot-matrix heatsink layer 22. In such a manner, the particles of the three-dimensional dot-matrix heatsink layer 22 have similar sizes and are arranged in a regular manner.

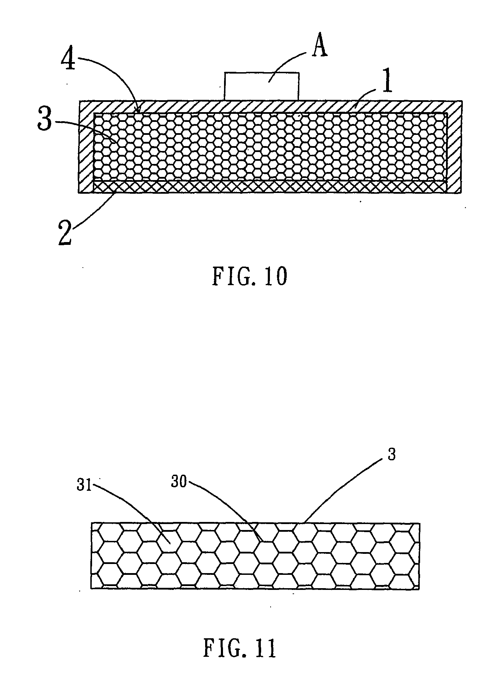

Referring to Figs. 10 and 11, the heat sink further comprises a secondary non-metallic heatsink layer 3 mounted in the hollow receiving space 4 and located between the metallic heat conducting layer 1 and the non-metallic heatsink layer 2. The non-metallic heatsink layer 2 is located at a bottom of the secondary non-metallic heatsink layer 3. The secondary non-metallic heatsink layer 3 has a three-dimensional heatsink structure and includes a plurality of skeletons 30 each having a good heat conductivity and each having an inside provided with a conduit 31. The conduits 31 of the skeletons 30 of the secondary non-metallic heatsink layer 3 are connected to each other to increase the surface area of the secondary non-metallic heatsink layer 3 so as to enhance the heat dissipation effect. Thus, when the secondary non-metallic heatsink layer 3 is mounted in the hollow receiving space 4, the conduits 31 of the skeletons 30 of the secondary non-metallic heatsink layer 3 have a greater heat convection effect so as to enhance the heat dissipation effect.

In fabrication, the secondary non-metallic heatsink layer 3 is made by the steps of: preparing slurry, attaching and sintering. The step of preparing slurry includes preparing materials the same as that of the non-metallic heatsink layer 2 and mixing and stirring the materials to form a slurry. In the step of attaching, the slurry is attached onto a molding carrier evenly. The molding carrier is made of organic material and includes a plurality of skeletons (such as sponges) and a plurality of conduits connected to each other. In the step of sintering, the molding carrier and the slurry are sintered, so that the molding carrier and the slurry are combined together to form the secondary non-metallic heatsink layer 3.

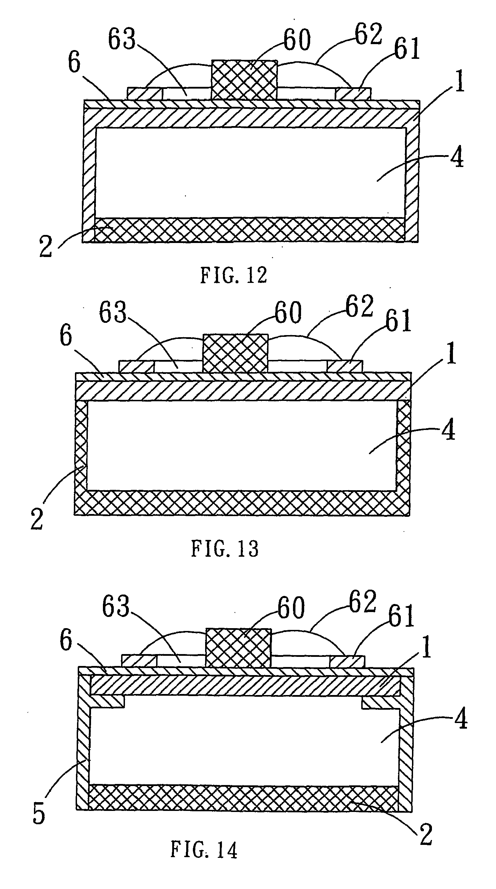

Referring to Figs. 12-14, the heat sink further comprises an insulating layer 6 mounted on a surface of the metallic heat conducting layer 1, a circuit 61 mounted on the insulating layer 6, a plurality of LED (light emitting diode) crystals 60 mounted on the insulating layer 6, a plurality of conducting wires 62 connected between the circuit 61 and the LED crystals 60, and a reflective layer 63 mounted on the insulating layer 6 and located between the circuit 61 and the LED crystals 60. In such a manner, the non-metallic heatsink layer 2 has a porous structure so that the air contained in the hollow receiving space 4 can pass through the non-metallic heatsink layer 2 to produce a heat convection effect. Thus, the heat produced by the LED crystals 60 is conducted quickly and distributed evenly on the metallic heat conducting layer 1 to create an evenly heat conducting effect. At the same time, the hollow receiving space 4 has a heat convection effect to quickly transfer the heat from the metallic heat conducting layer 1 to the non-metallic heatsink layer 2 which produces a heatsink effect to dissipate the heat so that the heat produced by the LED crystals 60 is dissipated quickly by provision of the metallic heat conducting layer 1, the hollow receiving space 4 and the non-metallic heatsink layer 2. In addition, the light produced by the LED crystals 60 is reflected by the reflective layer 63 to enhance the heat dissipation efficiency.

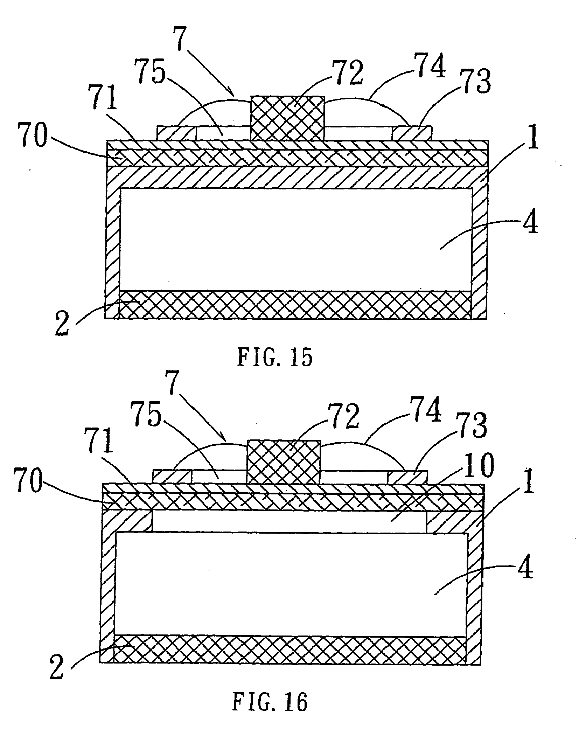

Referring to Fig. 15, the heat sink further comprises an LED module 7 mounted on a surface of the metallic heat conducting layer 1. The LED module 7 includes a substrate 70 mounted on the surface of the metallic heat conducting layer 1, an insulating layer 71 mounted on the substrate 70, a circuit 73 mounted on the insulating layer 71, a plurality of LED crystals 72 mounted on the insulating layer 71, a plurality of conducting wires 74 connected between the circuit 73 and the LED crystals 72, and a reflective layer 75 mounted on the insulating layer 71 and located between the circuit 73 and the LED crystals 72. In such a manner, the non-metallic heatsink layer 2 has a porous structure so that the air contained in the hollow receiving space 4 can pass through the non-metallic heatsink layer 2 to produce a heat convection effect. Thus, the heat produced by the LED crystals 72 is conducted quickly and distributed evenly on the metallic heat conducting layer 1 to create an evenly heat conducting effect. At the same time, the hollow receiving space 4 has a heat convection effect to quickly transfer the heat from the metallic heat conducting layer 1 to the non-metallic heatsink layer 2 which produces a heatsink effect to dissipate the heat so that the heat produced by the LED crystals 72 is dissipated quickly by provision of the metallic heat conducting layer 1, the hollow receiving space 4 and the non-metallic heatsink layer 2. In addition, the light produced by the LED crystals 72 is reflected by the reflective layer 75 to enhance the heat dissipation efficiency.

Referring to Fig. 16, the metallic heat conducting layer 1 has a side provided with a connecting hole 10 connected to the substrate 70 of the LED module 7 to connect the hollow receiving space 4 to the substrate 70 of the LED module 7 to enhance the heat dissipation efficiency.

Accordingly, the heat produced by the heat source (A) is conducted quickly and distributed evenly on the metallic heat conducting layer 1 to create an evenly heat conducting effect, while the hollow receiving space 4 has a heat convection effect to quickly transfer the heat from the metallic heat conducting layer 1 to the non-metallic heatsink layer 2 which produces a heatsink effect to dissipate the heat so that the heat produced by the heat source (A) is dissipated quickly by provision of the metallic heat conducting layer 1, the hollow receiving space 4 and the non-metallic heatsink layer 2.

Although the invention has been explained in relation to its preferred embodiment(s) as mentioned above, it is to be understood that many other possible modifications and variations can be made without departing from the scope of the present invention. It is, therefore, contemplated that the appended claim or claims will cover such modifications and variations that fall within the true scope of the invention.

## Claims

1. A heat sink, comprising:
a metallic heat conducting layer (1);
a non-metallic heatsink layer (2) combined with the metallic heat conducting layer (1) and having a porous structure; and
a hollow receiving space (4) defined between the metallic heat conducting layer (1) and the non-metallic heatsink layer (2).

2. The heat sink in accordance with claim 1, wherein the hollow receiving space (4) is formed by the metallic heat conduct layer (1);
the metallic heat conducting layer (1) has a hollow inside to define the hollow receiving space (4) and has an open end for mounting the non-metallic heatsink layer (2);
the open end being sealed by the non-metallic heatsink layer (2).

3. The heat sink in accordance with claim 1, wherein the hollow receiving space (4) is formed by the non-metallic heatsink layer (2);
the non-metallic heatsink layer (2) has a hollow inside to define hollow receiving space (4) and has an open end for mounting the metallic heat conducting layer (1),
the open end being sealed by the metallic heat conducting layer (1).

4. The heat sink in accordance with claim 1, wherein the heat sink further comprises a packing layer (5) mounted between the metallic heat conducting layer (1) and the non-metallic heatsink layer (2); the hollow receiving space (4) is formed by the packing layer (5); and
the packing layer (5) has a hollow inside to define the hollow receiving space (4) and has an open first end for mounting the metallic heat conducting layer (1) and an open second end for mounting the non-metallic heatsink layer (2); two open ends being sealed by the metallic heat conducting layer (1) and the non-metallic heatsink layer (2) respectively.

5. The heat sink in accordance with claim 1, wherein the non-metallic heatsink layer (2) has a highly porous structure and contains non-metallic powders having good heat conductivity;
the non-metallic heatsink layer (2) has a porosity ranged between 20% and 80%;
the non-metallic powders have different diameters ranged between 20µm and 200µm.

6. The heat sink in accordance with claim 5, wherein the non-metallic powders are mixed with metallic powders having good heat conductivity to form composite powders having particles of different diameters ranged between 50µm and 500µm.

7. The heat sink in accordance with claim 1, wherein the non-metallic heatsink layer (2) has a three-dimensional heat dissipation face (20) which has a predetermined shape and has a matrix arrangement.

8. The heat sink in accordance with claim 1, further comprising a three-dimensional dot-matrix heatsink layer (21) mounted on a surface of the non-metallic heatsink layer (2) and arranged in an irregular manner.

9. The heat sink in accordance with claim 1, further comprising a three-dimensional dot-matrix heatsink layer (22) mounted on a surface of the non-metallic heatsink layer (2) and arranged in a regular manner.

10. The heat sink in accordance with claim 1, further comprising a secondary non-metallic heatsink layer (3) mounted in the hollow receiving space (4) and located between the metallic heat conducting layer (1) and the non-metallic heatsink layer (2).

11. The heat sink in accordance with claim 10, wherein
the secondary non-metallic heatsink layer (3) has a three-dimensional heatsink structure and includes a plurality of skeletons (30) each having a good heat conductivity and each having an inside provided with a conduit (31);
the conduits (31) of the skeletons (30) of the secondary non-metallic heatsink layer (3) are connected to each other.

12. The heat sink in accordance with claim 10, wherein the non-metallic heatsink layer (2) is located at a bottom of the secondary non-metallic heatsink layer (3).

13. The heat sink in accordance with claim 1, further comprising
an insulating layer (6) mounted on a surface of the metallic heat conducting layer (1);
a circuit (61) mounted on the insulating layer (6);
a plurality of LED (light emitting diode) crystals (60) mounted on the insulating layer (6); and
a plurality of conducting wires (62) connected between the circuit (61) and the LED crystals (60).

14. The heat sink in accordance with claim 13, further comprising
a reflective layer (63) mounted on the insulating layer (6) and located between the circuit (61) and the LED crystals (60).

15. The heat sink in accordance with claim 1, further comprising an LED module (7) mounted on a surface of the metallic heat conducting layer (1), wherein the LED module includes
a substrate (70) mounted on the surface of the metallic heat conducting layer (1);
an insulating layer (71) mounted on the substrate (70); a circuit (73) mounted on the insulating layer (71); a plurality of LED crystals (72) mounted on the insulating layer (71); and
a plurality of conducting wires (74) connected between the circuit (73) and the LED crystals (72).

16. The heat sink in accordance with claim 15, wherein the LED module (7) further includes
a reflective layer (75) mounted on the insulating layer (71) and located between the circuit (73) and the LED crystals (72).

17. The heat sink in accordance with claim 15, wherein the metallic heat conducting layer (1) has a side provided with a connecting hole (10) connected to the substrate (70) of the LED module (7) to connect the hollow receiving space (4) to the substrate (70) of the LED module (7).

## Amended claims

### Amended claims in accordance with Rule 137(2) EPC.

**1.** A heat sink, comprising:
a metallic heat conducting layer (1);
a non-metallic heatsink layer (2) combined with the metallic heat conducting layer (1) and having
a porous structure; and
a hollow receiving space (4) defined between the metallic heat conducting layer (1) and the non-metallic heatsink layer (2), **characterized by** further comprising an LED module (7) mounted on a surface of the metallic heat conducting layer (1), wherein the LED module includes
a substrate (70) mounted on the surface of the metallic heat conducting layer (1), said layer (1) having a side provided with a connecting hole (10) connected to the substrate (70) to connect the hollow receiving space (4) to the substrate (70) of the LED module 7); an insulating layer (71) mounted on the substrate (70);
a circuit (73) mounted on the insulating layer(71); a plurality of LED crystals (72) mounted on the insulating layer (71); and
a plurality of conducting wires (74) connected between the circuit (73) and the LED crystals (72).

**2.** The heat sink in accordance with claim 1, wherein the hollow receiving space (4) is formed by the metallic heat conduct layer (1);
the metallic heat conducting layer (1) has a hollow inside to define the hollow receiving space (4) and has an open end for mounting the non-metallic heatsink layer (2);
the open end being sealed by the non-metallic heatsink layer (2).

**3.** The heat sink in accordance with claim 1, wherein the hollow receiving space (4) is formed by the non-metallic heatsink layer (2);
the non-metallic heatsink layer (2) has a hollow inside to define hollow receiving space (4) and has an open end for mounting the metallic heat conducting layer (1),
the open end being sealed by the metallic heat conducting layer (1).

**4.** The heat sink in accordance with claim 1, wherein the heat sink further comprises a packing layer (5) mounted between the metallic heat conducting layer (1) and the non-metallic heatsink layer (2); the hollow receiving space (4) is formed by the packing layer (5); and
the packing layer (5) has a hollow inside to define the hollow receiving space (4) and has an open first end for mounting the metallic heat conducting layer (1) and an open second end for mounting the non-metallic heatsink layer (2);
two open ends being sealed by the metallic heat conducting layer (1) and the non-metallic heatsink layer (2) respectively.

**5.** The heat sink in accordance with claim 1, wherein the non-metallic heatsink layer (2) has a highly porous structure and contains non-metallic powders having good heat conductivity;
the non-metallic heatsink layer (2) has a porosity ranged between 20% and 80%;
the non-metallic powders have different diameters ranged between 20µm and 200µm.

**6.** The heat sink in accordance with claim 5, wherein the non-metallic powders are mixed with metallic powders having good heat conductivity to form composite powders having particles of different diameters ranged between 50µm and 500µm.

**7.** The heat sink in accordance with claim 1, wherein the non-metallic heatsink layer (2) has a three-dimensional heat dissipation face (20) which has a predetermined shape and has a matrix arrangement.

**8.** The heat sink in accordance with claim 1, further comprising a three-dimensional dot-matrix heatsink layer (21) mounted on a surface of the non-metallic heatsink layer (2) and arranged in an irregular manner.

**9.** The heat sink in accordance with claim 1, further comprising a three-dimensional dot-matrix heatsink layer (22) mounted on a surface of the non-metallic heatsink layer (2) and arranged in a regular manner.

**10.** The heat sink in accordance with claim 1, further comprising a secondary non-metallic heatsink layer (3) mounted in the hollow receiving space (4) and located between the metallic heat conducting layer (1) and the non-metallic heatsink layer (2).

**11.** The heat sink in accordance with claim 10, wherein
the secondary non-metallic heatsink layer (3) has a three-dimensional heatsink structure and includes a plurality of skeletons (30) each having a good heat conductivity and each having an inside provided with a conduit (31);
the conduits (31) of the skeletons (30) of the secondary non-metallic heatsink layer (3) are connected to each other.

**12.** The heat sink in accordance with claim 10, wherein the non-metallic heatsink layer (2) is located at a bottom of the secondary non-metallic heatsink layer (3).

**13.** The heat sink in accordance with claim 1, wherein the LED module (7) further includes
a reflective layer (75) mounted on the insulating layer (71) and located between the circuit (73) and the LED crystals (72).
